# EUROPEAN PATENT APPLICATION

(11) **EP 2 426 732 A2**
(43) Date of publication of application: **07.03.2012**
(21) Application number: 10820858.8
(22) Date of filing: 30.09.2010
(51) Int. Cl.: H01L 31/042

(54) **PHOTOVOLTAIC DEVICE AND MANUFACTURING METHOD THEREOF**

(30) Priority: 01.10.2009 KR 20090093697
(71) Applicant: LG Innotek Co., Ltd., Seoul 100-714 (KR)
(72) Inventor: SUNG, Myoung Seok, Seoul 100-714 (KR)
(74) Representative: Novagraaf Technologies
(86) International application number: PCT/KR2010/006712
(87) International publication number: WO 2011/040785

(57) **Abstract**

Provided are a solar cell apparatus and a method of manufacturing the same. The solar cell apparatus includes: a substrate; a back electrode layer on the substrate; a light absorbing layer on the back electrode layer; and a front electrode layer on the light absorbing layer. A groove is formed in an outline portion of the substrate.

## Description

### Technical Field

The present disclosure relates to a solar cell apparatus and a method of manufacturing the same.

### Background Art

As the demands for energy are increased recently, the developments for a solar battery converting solar energy into electric energy are in progress.

Especially, a (Cu(In,Ga)Se₂ (CIGS) based solar battery is widely used, which is a pn hetero junction device with a substrate structure including a substrate, a metal back electrode layer, a p-type CIGS based light absorbing layer, a high resistance buffer layer, and an n-type window layer.

Those layers constituting a solar battery are sequentially deposited on the substrate, each layer having a partially different deposition level. This may cause electrical defects in the solar battery in an edge area of the substrate.

Accordingly, during the forming of the solar battery, a process for removing the structures in the edge area of the substrate is performed through a mechanical method using a tip.

### Disclosure

### Technical Problem

Embodiments provide a solar cell apparatus having easy manufacturing processes and improved electrical property and a method of manufacturing the same.

### Technical Solution

In one embodiment, a solar cell apparatus includes:
a substrate;
a back electrode layer on the substrate;
a light absorbing layer on the back electrode layer; and
a front electrode layer on the light absorbing layer,
wherein a groove is formed in an outline portion of the substrate.

In another embodiment, a solar cell apparatus includes:
a substrate including a cell area and an edge area surrounding the cell area;
a back electrode layer in the cell area;
an insulation layer in the edge area;
a light absorbing layer on the back electrode layer; and
a front electrode layer on the light absorbing layer.

In further another embodiment, a method of manufacturing a solar cell apparatus includes:
forming a sacrificial layer on a substrate;
forming a back electrode layer on the substrate and the sacrificial layer;
forming a light absorbing layer on the back electrode layer;
forming a front electrode layer on the light absorbing layer; and
removing a portion or all of the sacrificial layer, an outline portion of the back electrode layer, an outline portion of the light absorbing layer, and an outline portion of the front electrode layer.

### Advantageous Effects

In a solar cell apparatus according to an embodiment, after a sacrificial layer is formed and a back electrode layer is formed on the sacrificial layer, the sacrificial layer and the back electrode layer are simultaneously patterned to form the solar cell apparatus. Especially, the sacrificial layer may include a material that is mechanically patterned easily.

Since the back electrode layer is formed on the sacrificial layer, it may be easily patterned. That is, the back electrode layer may be patterned through a mechanical scribing process, without using laser.

Accordingly, the solar cell apparatus according to an embodiment may be easily manufactured.

Additionally, the sacrificial layer may be formed in a groove in a substrate. Accordingly, byproducts may occur during an edge removing process for removing outline portions of the back electrode layer, the light absorbing layer, and the front electrode layer, and may be separated in a groove having the sacrificial layer removed.

Accordingly, the solar cell apparatus according to an embodiment may prevent a short due to byproducts and may have improved electrical property.

### Description of Drawings

Fig. 1 is a plan view of a solar cell apparatus according to an embodiment.
Fig. 2 is a sectional view taken along the line I-I' of Fig. 1.
Fig. 3 is a sectional view of a solar cell apparatus according to another embodiment.
Figs. 4 to 11 are views illustrating manufacturing processes of a solar cell apparatus according to an embodiment.
Fig. 12 is a plan view of a solar cell apparatus according to another embodiment.
Fig. 13 is a sectional view taken along the line II-II' of Fig. 12.
Figs. 14 to 17 are views illustrating manufacturing processes of a solar cell apparatus according to another embodiment.

### Best Mode

In the description of embodiments, it will be understood that when a substrate, layer, film, or electrode is referred to as being 'on' or 'under' another substrate, layer, film, or electrode, the terminology of 'on' and 'under' includes both the meanings of 'directly' and 'indirectly'. Further, the reference about 'on' and 'under' each component will be made on the basis of drawings. In addition, the sizes of elements and the relative sizes between elements may be exaggerated for further understanding of the present disclosure.

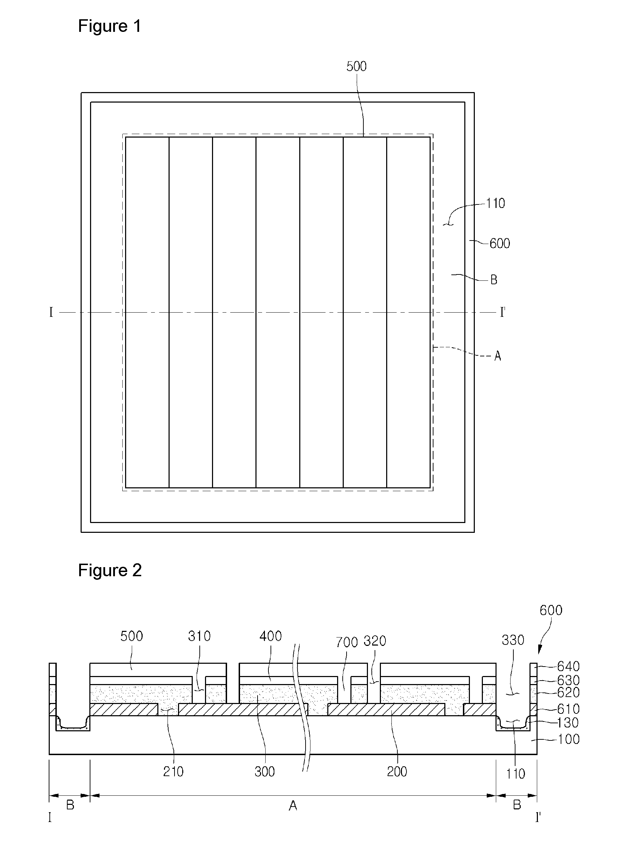

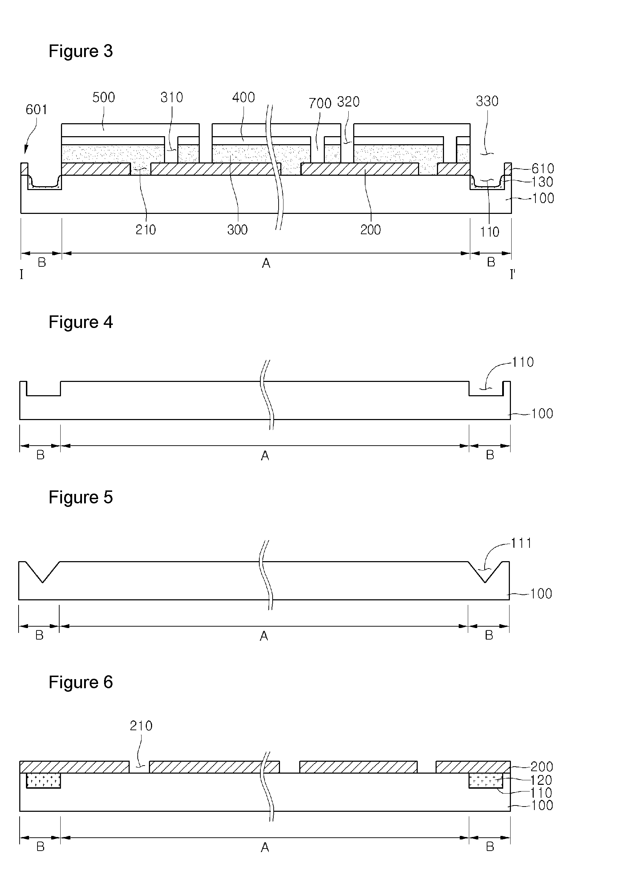

Fig. 1 is a plan view of a solar cell apparatus according to an embodiment. Fig. 2 is a sectional view taken along the line I-I' of Fig. 1. Fig. 3 is a sectional view of a solar cell apparatus according to another embodiment.

Referring to Figs. 1 and 2, the solar cell apparatus includes a support substrate 100, a dummy sacrificial layer 130, a back electrode layer 200, a light absorbing layer 300, a buffer layer 400, a front electrode layer 500, a plurality of connection parts 700, and a dummy structure 600.

The support substrate 100 has a plate shape and supports the back electrode layer 200, the light absorbing layer 300, the buffer layer 400, the front electrode layer 500, the connection parts 700, and the dummy structure 600.

The support substrate 100 may be an insulator. The support substrate 100 may be a glass substrate, a plastic substrate, or a metal substrate. In more detail, the support substrate 100 may be a soda lime glass substrate. The support substrate 100 may be transparent. Additionally, the support substrate 100 may be rigid or flexible.

The support substrate 100 includes a cell area A and an edge area B. In more detail, the support substrate 100 includes the cell area A and the edge area B. That is, the cell area A and the edge area B are defined in the support substrate 100.

The cell area A is defined at the middle portion of the support substrate 100. The cell area A may have a rectangular shape. The cell area A may be largely disposed on the top side of the support substrate 100.

The edge area B surrounds the cell area A. The edge area B extends along the surrounding of the cell area A. That is, when the edge area B is seen from the top, it may have a ring shape.

A groove 110 is formed in the support substrate 100. The groove 110 is formed in the edge area B. The groove 110 surrounds the cell area A. Additionally, the groove 110 surrounds the back electrode layer 200. Additionally, the groove 110 is formed between the back electrode layer and the dummy structure 600.

Additionally, the groove 110 surrounds the light absorbing layer 300, the buffer layer 400, and the front electrode layer 500. The groove 110 may have a closed loop shape. Additionally, the groove 110 may have a rectangular cross-section to have a flat bottom side. Unlike this, the groove 100 may have an inverted triangular cross-section.

The groove 110 has a width of about 0.5 cm to about 10 cm. The groove 110 has a depth of about 0.1 mm to about 5 mm.

The dummy sacrificial layer 130 is disposed in the edge area B. The dummy sacrificial layer 130 is disposed in the groove 110. The dummy sacrificial layer 130 may be formed along the inner side and the bottom side of the groove 110. The dummy sacrificial layer 130 may be formed lower than the top side of the support substrate 100.

Unlike this, the dummy sacrificial layer 130 may be disposed on the top side of the support substrate 100.

The top side of the dummy sacrificial layer 130 has high roughness. That is, the top side of the dummy sacrificial layer 130 may be formed after cut by a tip. Additionally, the dummy sacrificial layer 130 may not be uniformly formed in the groove 110. That is, the dummy sacrificial layer 130 may include an open area exposing the lateral sides and the bottom side of the groove 110.

The dummy sacrificial layer 130 includes oxide. In more detail, the dummy sacrificial layer 130 may include an oxide having a crystal structure. The dummy sacrificial layer 130 includes an insulator. Accordingly, the dummy sacrificial layer 130 is an insulating layer. An oxide used for the dummy sacrificial layer 130 may include titanium oxide (TiO₂), silicon oxide (SiO₂) or zinc oxide (ZnO).

Besides that, various materials vulnerable to mechanical impact may be used for the dummy sacrificial layer 130.

The back electrode layer 200 is disposed on the support substrate 100. The back electrode layer 200 is disposed in the cell area A. The back electrode layer 200 may be disposed only in the cell area A.

When the back electrode layer 200 is seen from the top, it may have a rectangular shape. The back electrode layer 200 is a conductive layer. A material used for the back electrode layer 200 may include a metal such as Mo.

Additionally, the back electrode layer 200 may include at least two layers. At this point, each layer may be formed of the same metal or respectively different metals.

First through holes 210 are formed in the back electrode layer 200. The first through holes 210 are open areas exposing the top side of the support substrate 100. When the first through holes 210 are send from the top, they may have a shape extending in one direction.

The first through holes 210 may have a width of about 80 µm to about 200 µm.

The back electrode layer 200 is divided into a plurality of back electrodes by the first through holes 210. That is, the back electrodes are defined by the first through holes 210.

The back electrodes are spaced from each other by the first through holes 210. The back electrodes are disposed in a stripe shape.

Unlike this, the back electrodes may be disposed in a matrix shape. At this point, when the first through holes 210 are seen from the top, it may have a lattice shape.

The light absorbing layer 300 is disposed on the back electrode layer 200. The light absorbing layer 300 is disposed in the cell area A. The light absorbing layer 300 may be disposed only in the cell area A. For example, the outline of the light absorbing layer 300 may correspond to that of the back electrode layer 200. Additionally, the first through holes 210 are filled with a material of the light absorbing layer 300.

The light absorbing layer 300 may include a Group I-III-VI based compound. For example, the light absorbing layer 300 may have a Cu(In,Ga)Se₂ based (CIGS based) crystal structure, or a Cu-In-Se based (CIS based) or Cu-Ga-Se based (CGS based) crystal structure.

The light absorbing layer 300 may have an energy band gap of about 1 eV to about 1.8 eV.

The buffer layer 400 is disposed on the light absorbing layer 300. The buffer layer 400 is disposed in the cell area A. The buffer layer 400 and the light absorbing layer 300 have the same plane shape. The buffer layer 400 includes CdS and has an energy band gap of about 2.2 eV to about 2.4 eV.

Second through holes 310 are formed in the light absorbing layer 300 and the buffer layer 400. The second through holes 310 penetrate the light absorbing layer 300. Additionally, the second through holes 310 are open areas exposing the top side of the back electrode layer 200.

The second through holes 310 are formed adjacent to the first through holes 210. That is, when some of the second through holes 310 are seen from the top, they are formed next to the first through holes 210.

The second through holes 310 may have a width of about 80 **µm** to about 200 µm.

Additionally, the light absorbing layer 300 defines a plurality of light absorbing parts by the second through holes 310. That is, the light absorbing layer 300 is divided into the plurality of light absorbing parts by the second through holes 310.

The buffer layer 400 includes a plurality of buffers divided by the second through holes 310. That is, the buffer layer 400 is divided into the plurality of buffers divided by the second through holes 310.

The front electrode layer 500 is disposed on the buffer layer 400. The front electrode layer 500 is disposed in the cell area A. The front electrode layer 500 may have a corresponding plane shape to the light absorbing layer 300.

The outlines of the back electrode layer 200, the light absorbing layer 300, and the front electrode layer 500 correspond to each other. That is, The outer sides of the back electrode layer 200, the light absorbing layer 300, and the front electrode layer 500 are disposed on the same plane. Additionally, the outlines of the back electrode layer 200, the light absorbing layer 300, and the front electrode layer 500 are adjacent to the groove 110.

The front electrode layer 500 is a transparent and conductive layer. The front electrode layer 500 includes a conductive oxide. For example, the front electrode layer 500 may include zinc oxide (ZnO), induim tin oxide (ITO) or induim zinc oxide (IZO).

Additionally, the oxide may include a conductive dopant such as Al, Al₂O₃, Mg, or Ga. In more detail, the front electrode layer 500 may include Al doped zinc oxide (AZO) or Ga doped zinc oxide (GZO).

Third through holes 320 are formed in the buffer layer 400 and the front electrode layer 500. The third through holes 320 are open areas exposing the top side of the back electrode layer 200. For example, the third through holes 320 may have a width of about 80 µm to about 200 µm.

The third through holes 320 are formed adjacent to the second through holes 310. In more detail, the third through holes 320 are formed next to the second through holes 310. That is, when the third through holes 320 are seen from the top, they are disposed parallel to the second through holes 310.

The front electrode layer 500 is divided into a plurality of front electrodes by the third through holes 320. That is, the front electrodes are defined by the third through holes 320.

The front electrodes have a corresponding shape to the back electrodes. That is, the front electrodes are disposed in a stripe shape. Unlike this, the front electrodes may be disposed in a matrix shape.

Additionally, the front electrodes are divided into a plurality of cells C1, C2,... by the third through holes 320. In more detail, the plurality of cells C1, C2,... are defined by the second through holes 310 the third through holes 320. That is, the solar cell apparatus includes the plurality of cells C1, C2,... defined by the second through holes 310 the third through holes 320.

The dummy structure 600 is disposed at the outside of an area having the groove 110. That is, the dummy structure 600 is disposed between the groove 110 and the lateral side of the support substrate 100. The dummy structure 600 is disposed on the top side of the support substrate 100.

The dummy structure 600 is spaced from the back electrode layer 200 by the groove 110. That is, the dummy structure 600 and the back electrode layer 200 are spaced from each other by the width of the groove 110.

The dummy structure 600 may directly contact the top side of the substrate. The dummy structure 600 includes a first dummy layer 610, a second dummy layer 620, a third dummy layer 630, and a fourth dummy layer 640. The first dummy layer 610 and the back electrode layer 200 are formed of the same material. The second dummy layer 620 is disposed on the first dummy layer 610 and is formed of the same material as the light absorbing layer 300. The third dummy layer 630 is disposed on the second dummy layer 620 and is formed of the same material as the buffer layer 400. The fourth dummy layer 640 is disposed on the third dummy layer 630 and is formed of the same material as the front electrode layer 500.

As shown in Fig. 3, the dummy structure 600 may include only the first dummy layer 610 and may not include other dummy layers. That is, the second dummy layer 620, the third dummy layer 630, and the fourth dummy layer 640 may be removed.

The connection parts 700 are disposed in the second through holes 310. The connection parts 700 extend from the front electrode layer 500 to the bottom and contact the back electrode layer 200.

Accordingly, the connection parts 700 connect respectively adjacent cells. In more detail, the connection parts 700 connect the front electrode and the back electrode in each of the respectively adjacent cells.

The connection part 700 and the front electrode layer 500 are integrally formed. That is, the connection parts 700 are formed of the same material as the front electrode layer 500.

In order to form the solar cell apparatus, a sacrificial layer 120 is formed in the groove 110 and the outline portion of the back electrode layer 200 may be patterned together with the sacrificial layer 120.

Accordingly, the back electrode layer 200 may be patterned through a mechanical scribing method. Accordingly, the solar cell apparatus may be easily manufactured.

Additionally, byproducts occurring when the back electrode layer 200, the light absorbing layer 300, the buffer layer 400, and the front electrode layer 500 are patterned may be separated by the groove 110. That is, the byproducts may remain on the lateral side of the back electrode layer 200 and the lateral side of the front electrode layer 500 to prevent a short.

Accordingly, the solar cell apparatus prevents a short of the back electrode layer 200 and the front electrode layer 500, thereby providing improved electrical property. Accordingly, the solar cell apparatus according to an embodiment may have improved photoelectric conversion efficiency.

Figs. 4 to 11 are views illustrating manufacturing processes of a solar cell apparatus according to an embodiment. Description of the manufacturing method will refer to that of the solar cell apparatus. That is, the description of the above solar cell apparatus may be substantially combined to that of this manufacturing method.

Referring to Fig. 4, a groove 110 is formed in a support substrate 100 including a cell area A and an edge area B. The groove 110 is formed in the edge area B. A structure in the edge area B may be easily removed by the groove 110.

At this point, the groove 110 is formed being spaced from the outline of the support substrate 100.

In this embodiment, the groove 110 having a rectangular cross-section with the flat bottom side is illustrated, but is not limited thereto. That is, the groove 111 as shown in Fig. 5 may have an inverted triangular cross-section with the narrower bottom side.

The support substrate 100 may be formed of glass. Additionally, the support substrate 100 may include a ceramic (such as alumina) substrate, a stainless steel or titanium substrate, or a polymer substrate. In more detail, the glass substrate may be formed of soda lime glass and the polymer substrate may be formed of polyimide. Additionally, the support substrate 100 may be rigid or flexible.

Referring to Fig. 6, a sacrificial layer 120 is formed in the groove 110. That is the sacrificial layer 120 is formed in the edge area B. The sacrificial layer 120 may be formed on the top side of the support substrate 100.

The sacrificial layer 120 may be formed through a physical vapor deposition process such as a sputtering process. Unlike this, after the inner side of the groove 110 is filled with a paste and then the filling paste is sintered, the sacrificial layer 120 may be formed.

The sacrificial layer 120 is formed of an insulator. That is, the sacrificial layer 120 is an insulator. Additionally, the sacrificial layer 120 includes a mechanically weak material. In more detail, the sacrificial layer 120 may have greatly weaker mechanical strength than a back electrode layer 200 formed later. That is, the sacrificial layer 120 may be fragile to external mechanical impact.

The sacrificial layer 120 may be formed of an oxide. A material used for the sacrificial layer 120 may include titanium oxide (TiO₂), silicon oxide (SiO₂) or zinc oxide (ZnO).

Then, the back electrode layer 200 is formed on the sacrificial layer 120 and the support substrate 100. In order to form the back electrode layer 200, a metal such as Mo may be deposited on the top side of the sacrificial layer 120 and the support substrate 100.

Then, a plurality of first through holes 210 may be formed in the back electrode layer 200 through laser. The first through holes 210 may be formed through a photolithography process. The back electrode layer 200 is divided into a plurality of back electrodes by the first through holes 210. The plurality of back electrodes may be disposed in a stripe shape or a matrix shape and may correspond to each cell.

The back electrode layer 200 may be formed of a conductor such as metal. For example, the back electrode layer 200 may be formed using a molybdenum (Mo) target through a sputtering process. This is because Mo has high electrical conductivity, ohmic contact with a light absorbing layer 300, and high temperature stability under Se atmosphere.

Additionally, although not shown in the drawings, the back electrode layer 200 may be formed with at least one layer. When the back electrode layer 200 is formed with a plurality of layers, layers constituting the back electrode layer 200 may be formed of respectively different materials.

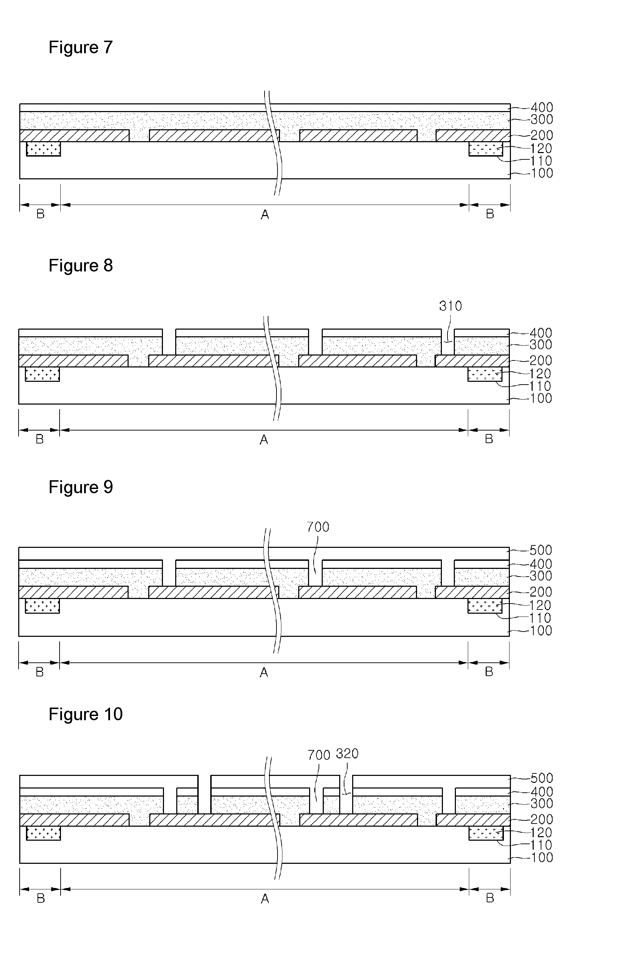

Referring to Fig. 7, the light absorbing layer 300 and a buffer layer 400 are formed on the back electrode layer 200.

The light absorbing layer 300 includes a Group I-III-VI based compound. In more detail, the light absorbing layer 300 includes a Cu(In, Ga)Se₂ based (CIGS based) compound.

Unlike this, the light absorbing layer 300 may includes a CuInSe₂ based (CIS based) compound or a CuGaSe₂ based (CIS based) compound.

For example, in order to form the light absorbing layer 300, a CIG based metal precursor layer is formed on the back electrode layer 200 by using a Cu target, an In target, and a Ga target.

Later, after a reaction of the metal precursor layer and Se is completed through a selenization process, a CIGS based light absorbing layer is formed.

Additionally, during the metal precursor layer forming process and the selenization process, an alkali element in the substrate 100 is diffused into the metal precursor layer and the light absorbing layer 300 through the back electrode layer 200.

The alkali element improves the grain size and crystallization of the light absorbing layer 300.

Additionally, the light absorbing layer 300 may be formed using Cu, In, Ga, and Se through co-evaporation.

The light absorbing layer 300 receives external incident light and converts it to electric energy. The light absorbing layer 300 generates photoelectron-motive force through photoelectric effect.

The buffer layer 400 may be formed with at least one layer. That is, the buffer layer 400 may be formed with a multi layer of at least one of CdS, ITO, ZnO, and i-ZnO, on the substrate 100 having the light absorbing layer 300.

At this point, the buffer layer 400 is an n-type semiconductor layer and the light absorbing layer 300 is a p-type semiconductor layer. Accordingly, the light absorbing layer 300 and the buffer layer 400 form a pn junction.

The buffer layer 400 is disposed between the light absorbing layer 300 and a front electrode layer 500 formed later.

That is, since the light absorbing layer 300 and the front electrode layer 500 have a large difference in lattice constant and energy band gap, the buffer layer 400 having an intermediate band gap of the layers 300 and 500 is inserted therebetween to form an excellent junction.

According to this embodiment, although one buffer layer 400 is formed on the light absorbing layer 300, the present invention is not limited thereto and thus the buffer layer 400 may be formed of a plurality of layers.

Referring to Fig. 8, second through holes 310 are formed in the light absorbing layer 300 and the buffer layer 400. The second through holes 310 may be formed through a mechanical process or and a laser process, thereby exposing a portion of the back electrode layer 200.

Referring to Fig. 9, the front electrode layer 500 and a plurality of connection lines 700 are formed by stacking a transparent conductive material on the buffer layer 400.

When the transparent conductive material is stacked on the buffer layer 400, it may be stacked in the second through holes 310. Accordingly, the connection lines 700 are formed in the second through holes 310. The back electrode layer 200 and the front electrode layer 500 are electrically connected to each other through the connection lines 700.

The front electrode layer 500 is formed of a zinc oxide doped with Al through a sputtering process on the substrate 100. The front electrode layer 500 is a window layer forming a pn junction with the light absorbing layer 300. Since the front electrode 500 serves as a transparent electrode at the front side of the solar battery, it is formed of ZnO having high light transmittance and excellent electrical conductivity.

At this point, an electrode having low resistance value may be formed by doping the ZnO with Al. A ZnO thin film, i.e., the front electrode layer 500, may be formed through an RF sputtering method using a ZnO target, a reactive sputtering method using a Zn target, and a metal organic chemical vapor deposition method.

Additionally, a double structure, in which an ITO thin film having excellent electro-optical property is deposited on a ZnO thin film, may be formed.

Referring to Fig. 10, third through holes 3 are formed in the light absorbing layer 300, the buffer layer 400, and the front electrode layer 500.

The third through holes 320 may be formed through a mechanical process or a laser process, thereby exposing a portion of the back electrode layer 200.

The buffer layer 400 and the front electrode layer 500 may be separated by the third through holes 320 and each cell is separated by the third through holes 320.

The front electrode layer 500, the buffer laye4 400, and the light absorbing layer 300 may be disposed in a stripe shape or a matrix shape by the third through holes 320.

The third through holes 320 are not limited to the above shape and may be formed in various shapes.

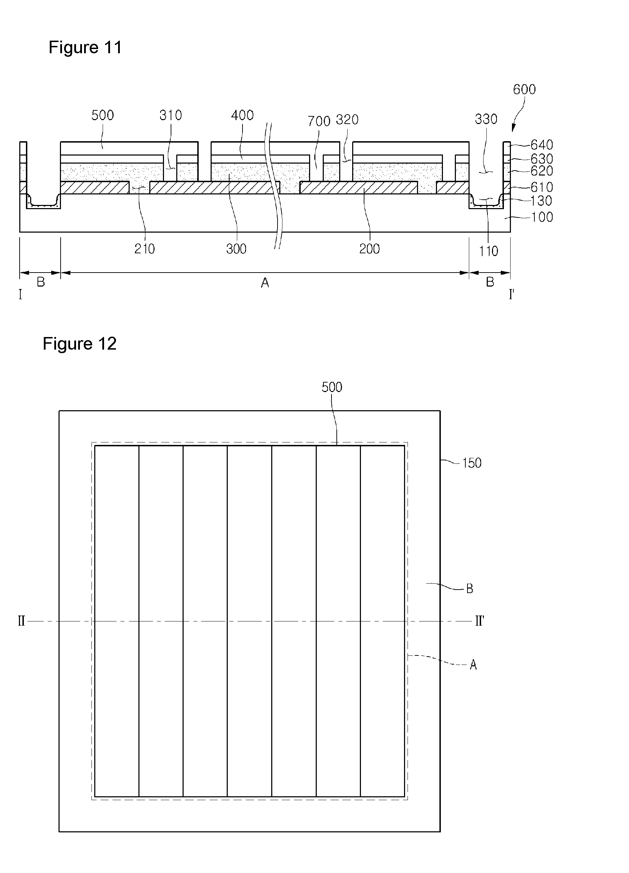

Referring to Fig. 11, a portion or all of the sacrificial layer 120, an outline portion of the back electrode layer 200, an outline portion of the light absorbing layer 300, an outline portion of the buffer layer 400, and an outline portion of the front electrode layer 500 are simultaneously removed. That is, an edge removing process is performed to form an edge pattern 330.

Such an edge removing process may be performed using a tip. That is, the edge removing process may be performed through a mechanical scribing process. Especially, since the sacrificial layer 120 is formed of a mechanically weak material, an outer portion of the back electrode layer 200 may be easily removed together with the sacrificial layer 120 by using a tip.

Accordingly, a portion of the sacrificial layer 120 is not removed and thus remains to form the dummy sacrificial layer 130. Since the dummy sacrificial layer 130 may be formed by cutting a top portion of the sacrificial layer 120, it may have a very rough top side.

Unlike this, most of the sacrificial layer 120 is removed so that the dummy sacrificial layer 130 may not be formed. At this point, even when most of the sacrificial layer 120 is removed, a material used for the sacrificial layer 120 may be detected in the groove 110. That is, an oxide such as TiO₂, SiO₂ or ZnO may remain in the groove 110.

Additionally, the back electrode layer 200, the light absorbing layer 300, the buffer layer 400, and the front electrode layer 500 in the edge area B are not completely removed. Accordingly, the back electrode layer 200, the light absorbing layer 300, the buffer layer 400, and the front electrode layer 500 in the edge area B are used to from a dummy structure 600.

A portion or all of the dummy structure 600 may be removed. The dummy structure 600 includes a first dummy layer 610, a second dummy layer 620, a third dummy layer 630, and a fourth dummy layer 640. At this point, the second dummy layer 620, the third dummy layer 630, and the fourth dummy layer 640 may be removed.

Like this, the edge pattern 330 may be formed through a scribing process using a tip on the groove 110 filled with the sacrificial layer 120. At this point, the entire sacrificial layer 120 is not removed, thereby forming the dummy sacrificial layer 130. The dummy sacrificial layer 130 may be formed lower than the top side of the support substrate 100.

During the edge removing process, laser may not be used to pattern the back electrode layer 200. That is, the edge pattern 330 is easily formed through a mechanical scribing process.

Accordingly, a method of manufacturing a solar cell apparatus according to an embodiment may easily improve the electrical property thereof.

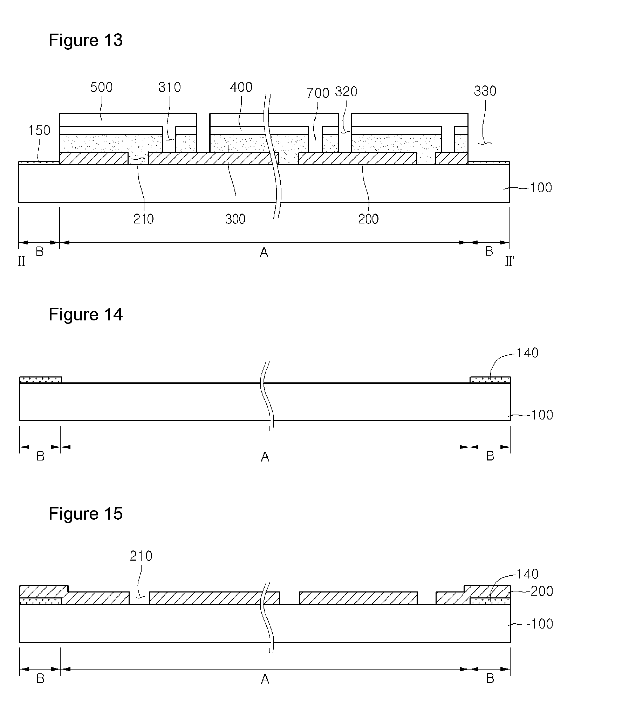

Fig. 12 is a plan view of a solar cell apparatus according to another embodiment. Fig. 13 is a sectional view taken along the line II-II' of Fig. 12. This embodiment refers to the above-mentioned embodiment and a support substrate and a dummy sacrificial layer will be additionally described. That is, except for the modified portions, description of the above solar battery and the method of manufacturing the same may be substantially combined to that of this embodiment.

Referring to Figs. 12, and 13, a groove 110 is not formed in the support substrate 100. The dummy sacrificial layer 150 may be directly formed on the top side of the support substrate 100. The dummy sacrificial layer 150 is formed in an edge area B.

The dummy sacrificial layer 150 may directly contact the top side of the support substrate 100. The dummy sacrificial layer 150 may be formed on the same plane as the back electrode layer 200. That is, the bottom side of the dummy sacrificial layer 150 may be formed on the same plane as that of the back electrode layer 200.

The dummy sacrificial layer 150 may directly contact the lateral side of the back electrode layer 200. The dummy sacrificial layer 150 may have a corresponding width to the edge area B. The dummy sacrificial layer 150 may have a very rough top side.

The solar cell apparatus according to this embodiment may easily form the edge pattern 330 without forming a groove in the support substrate 100.

Figs. 14 to 17 are views illustrating manufacturing processes of a solar cell apparatus according to another embodiment. Description of this manufacturing method will refer to those of the above-mentioned solar cell apparatus and method of manufacturing the same. That is, the description of the above solar cell apparatus and method of manufacturing the same may be substantially combined to that of this manufacturing method.

Referring to Fig. 14, a sacrificial layer 140 is formed on a support substrate 100. The sacrificial layer 140 is formed in the edge area B of the support substrate 100. The sacrificial layer 140 may have a closed loop shape and may be directly formed on the top side of the support substrate 100.

Referring to Fig. 15, a back electrode layer 200 is formed on the support substrate 100 and the sacrificial layer 140. The back electrode layer 200 may cover both the top side of the support substrate 100 and the top side of the sacrificial layer 140. The back electrode layer 200 is formed in a cell area A and the edge area B.

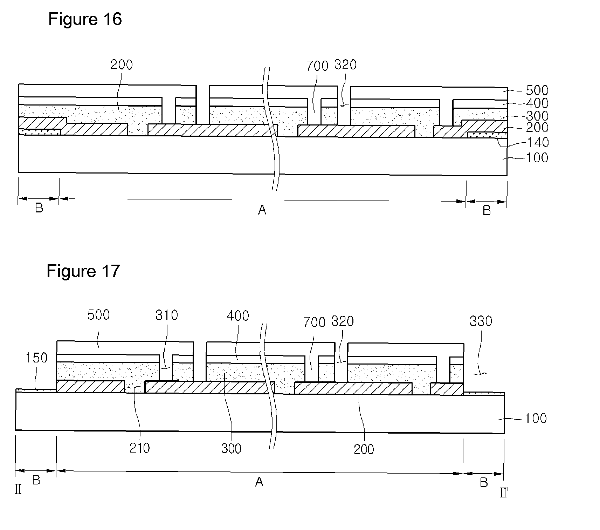

Referring to Fig. 16, a light absorbing layer 300, a buffer layer 400, and a front electrode layer 500 are sequentially formed on the back electrode layer 200. The light absorbing layer 300, the buffer layer 400, and the front electrode layer 500 cover the sacrificial layer 140. The light absorbing layer 300, the buffer layer 400, and the front electrode layer 500 are formed in the cell area A and the edge area B.

Referring to Fig. 17, a portion or all of the sacrificial layer 140, an outline portion of the back electrode layer 200, an outline portion of the light absorbing layer 300, an outline portion of the buffer layer 400, and an outline portion of the front electrode layer 500 are simultaneously removed to form an edge pattern 330. That is, portions corresponding to the edge area B are removed from the back electrode layer 200, the light absorbing layer 300, the buffer layer 400, and the front electrode layer 500.

At this point, since the sacrificial layer 140 may be fragile to external mechanical impact, it may be peeled off easily by a tip. Accordingly, the back electrode layer 200 corresponding to the edge area B may be easily removed together with the sacrificial layer 140 through a mechanical scribing process.

Accordingly, in relation to the method of manufacturing a solar cell apparatus according to this embodiment, the edge pattern 330 may be easily formed without forming a groove in the support substrate 100.

Additionally, the features, structures, and effects described in the above embodiments are included in at least one embodiment, but the present invention is not limited thereto. Furthermore, the features, structures, and effects in each embodiment may be combined or modified for other embodiments by those skilled in the art Accordingly, contents regarding the combination and modification should be construed as being in the scope of the present invention.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### Industrial Applicability

Embodiments are used for photovoltaic power generation fields.

## Claims

1. A solar cell apparatus comprising:
a substrate;
a back electrode layer on the substrate;
a light absorbing layer on the back electrode layer; and
a front electrode layer on the light absorbing layer,
wherein a groove is formed in an outline portion of the substrate.

2. The solar cell apparatus according to claim 1, wherein the groove surrounds the back electrode layer.

3. The solar cell apparatus according to claim 1, wherein the substrate comprises:
a cell area defined in a middle portion; and
an edge area defined around the cell area,
wherein
the back electrode layer is disposed in the cell area; and
the groove is formed in the edge area.

4. The solar cell apparatus according to claim 1, further comprising an insulation layer in the groove.

5. The solar cell apparatus according to claim 1, further comprising an oxide in the groove.

6. The solar cell apparatus according to claim 1, wherein titanium oxide, silicon oxide, or zinc oxide is disposed in the groove.

7. The solar cell apparatus according to claim 1, further comprising a dummy structure between the groove and a lateral side of the substrate.

8. The solar cell apparatus according to claim 7, wherein the dummy structure comprises a first dummy layer formed of the same material as the back electrode layer.

9. The solar cell apparatus according to claim 7, wherein the dummy structure is spaced from the back electrode layer.

10. A solar cell apparatus comprising:
a substrate including a cell area and an edge area surrounding the cell area;
a back electrode layer in the cell area;
an insulation layer in the edge area;
a light absorbing layer on the back electrode layer; and
a front electrode layer on the light absorbing layer.

11. The solar cell apparatus according to claim 10, wherein the back electrode layer and the insulation layer are disposed on the same plane.

12. The solar cell apparatus according to claim 10, wherein the back electrode layer and the insulation layer directly contact a top side of the substrate.

13. The solar cell apparatus according to claim 10, wherein the insulation layer surrounds the back electrode layer.

14. The solar cell apparatus according to claim 10, wherein outlines of the back electrode layer, the light absorbing layer, and the front electrode layer corresponding to that of the cell area.

15. A method of manufacturing a solar cell apparatus, the method comprising:
forming a sacrificial layer on a substrate;
forming a back electrode layer on the substrate and the sacrificial layer;
forming a light absorbing layer on the back electrode layer;
forming a front electrode layer on the light absorbing layer; and
removing a portion or all of the sacrificial layer, an outline portion of the back electrode layer, an outline portion of the light absorbing layer, and an outline portion of the front electrode layer.

16. The method according to claim 15, wherein
the substrate includes a cell area and an edge area surrounding the cell area;
a groove is formed in the edge area; and
the sacrificial layer is formed in the groove.

17. The method according to claim 15, wherein the sacrificial layer has a closed loop shape.

18. The method according to claim 15, wherein the sacrificial layer comprises an oxide.

19. The method according to claim 15, wherein the portion or all of the sacrificial layer, the outline portion of the back electrode layer, the outline portion of the light absorbing layer, and the outline portion of the front electrode layer are simultaneously removed through a mechanical method.
